# FASCICULE DE BREVET EUROPEEN

(11) **EP 0 582 969 B1**
(45) Date de publication et mention de la délivrance du brevet: **07.11.2001**
(21) Numéro de dépôt: 93112543.9
(22) Date de dépôt: 05.08.1993
(51) Int. Cl.: E05B 49/00

(54) **Dispositif de sécurité destiné à l'ouverture et/ou à la fermeture de portes notamment pour un véhicule automobile**
Sicherheitsvorrichtung zum Öffnen und/oder Schliessen von Toren, insbesondere eines Kraftfahrzeuges
Security device for opening and/or closing doors, especially of a motor vehicle

(30) Priorité: 11.08.1992 FR 9209982
(43) Date de publication de la demande: 16.02.1994
(73) Titulaire: The Swatch Group Management Services AG, 2501 Biel (CH)
(72) Inventeur: Daniel, Stoll, CH-2000 Neuchâtel (CH); Daniel, Clauss, CH-2034 Peseux (CH)
(74) Mandataire: Caron, Gérard

(56) Documents cités:
- EP-A- 0 162 132
- EP-A- 0 292 796
- FR-A- 2 067 752
- US-A- 3 764 982
- US-A- 4 609 780

## Description

La présente invention concerne un dispositif de sécurité destiné à l'ouverture et/ou à la fermeture de portes pour un véhicule automobile ou analogue et plus particulièrement un tel dispositif comportant une serrure électronique munie d'un clavier de commande destiné à l'introduction d'un code d'ouverture numérique ou alphanumérique.

Parmi les dispositifs de sécurité les plus connus pour l'ouverture et/ou la fermeture de portes de véhicules automobiles, on peut citer les dispositifs classiques à serrure comportant un mécanisme de verrouillage et de déverrouillage manoeuvré par une clef, identique ou non à la clef de l'antivol de direction et du contact du démarreur, et les dispositifs à radiofréquence ou infra-rouge qui permettent de commander à distance, à l'aide d'un émetteur, le verrouillage et/ou le déverrouillage de portes ou analogue.

Les dispositifs classiques à serrure à clef présentent de nombreux inconvénients.

En effet, ces dispositifs classiques nécessitent de prévoir, à chaque porte, une ouverture pour l'introduction de la clef. Une telle ouverture, bien qu'elle comprenne généralement un obturateur, n'assure pas l'étanchéité complète du mécanisme de la serrure. Cette ouverture est non seulement souvent la cause de blocage, notamment par le gel en période de grand froid, mais offre aussi une voie libre aux cambrioleurs et vandales pour forcer et/ou détériorer la serrure. Par ailleurs, comme avec toutes les serrures, il est nécessaire de disposer d'un double de la clé pour pouvoir utiliser le véhicule en cas de perte de cette dernière.

Les dispositifs à radiofréquence ou à infra-rouge sont, en général, utilisés en parallèle avec les dispositifs classiques à serrure à clef, raison pour laquelle ils ne permettent pas de résoudre tous les inconvénients mentionnés ci-dessus.

On connaît également par la demande de brevet européen No 0 292 796 un dispositif de verrouillage pour véhicule dans lequel les moyens d'activation du verrouillage comprennent un clavier à boutons-poussoirs installé à l'extérieur du véhicule et par l'intermédiaire duquel un code d'ouverture peut être introduit afin de déclencher le verrouillage après comparaison du code introduit avec un code d'ouverture. Le clavier est disposé à l'extérieur du véhicule, structurellement et fonctionnellement indépendant de la carrosserie dudit véhicule. Il est donc susceptible d'être arraché du véhicule, par exemple par un acte de vandalisme et, d'autre part, est soumis aux agressions climatiques et nécessite par conséquent l'utilisation de moyens d'étanchéité afin de garantir son bon fonctionnement dans le temps.

La présente invention a donc pour but principal de remédier aux inconvénients de l'art antérieur susmentionné en fournissant un dispositif de sécurité destiné à l'ouverture et/ou à la fermeture de portes notamment pour un véhicule automobile ou analogue protégé contre le vol et le vandalisme et qui en outre ne nécessite aucun élément de commande séparable tel qu'un clef ou un émetteur.

A cet effet l'invention a pour objet un dispositif de sécurité destiné à l'ouverture et/ou à la fermeture d'au moins une porte d'un véhicule automobile, caractérisé en ce qu'il comporte:
- au moins un clavier de commande, ledit clavier de commande comprenant au moins une touche pour introduire un code d'ouverture et/ou un code de fermeture, lesdites touches faisant partie intégrale d'un élément de carrosserie du véhicule et formant une surface extérieure continue dudit élément de carrosserie, ledit clavier étant muni d'éléments capteurs associés chacun à une touche correspondante, et situés sous ladite surface continue, lesdits éléments capteurs étant sensibles au toucher de ladite surface continue pour délivrer un code correspondant à la touche activée;
- un circuit apte à engendrer un signal de commande en réponse audit code délivré par le clavier de commande; et
- des moyens d'actionnement commandés par ledit signal de commande et assurant le verrouillage et/ou le déverrouillage de ladite porte.

Grâce à ces caractéristiques, le dispositif de sécurité ne présente aucun élément rapporté à l'extérieur du véhicule. De plus, il est étanche et par conséquent particulièrement fiable quelles que soient les conditions climatiques sous lesquelles il est utilisé ou le type d'agression à laquelle il peut être soumis.

Selon une caractéristique avantageuse de l'invention, le clavier est disposé sous le toit du véhicule.

Ainsi, le clavier se trouve à une hauteur qui convient au plus grand nombre d'utilisateurs, si bien que ces derniers peuvent le manipuler confortablement sans avoir à se pencher ou à se baisser dans une position inconfortable.

Selon un mode de réalisation préféré de l'invention, les éléments capteurs du clavier de commande comportent des éléments piézoélectriques.

L'utilisation de tels capteurs piézoélectriques dans le dispositif de sécurité de l'invention permet à ce dernier de s'affranchir de l'utilisation de toute pièce mobile apparaissant à l'extérieur du véhicule et ainsi d'augmenter l'esthétique du véhicule tout en garantissant une grande sécurité de fonctionnement du dispositif et un grande efficacité contre les tentatives de vol et/ou de vandalisme.

D'autres caractéristiques et avantages de l'invention apparaîtront plus clairement à la lecture de la description suivante d'un exemple de réalisation particulier du dispositif de sécurité, ladite description étant faite à titre purement illustratif en liaison avec les dessins joints dans lesquels:
- la figure 1 représente, schématiquement, un exemple de disposition d'un dispositif de sécurité de l'invention dans un véhicule automobile;
- la figure 2 montre le détail d'un clavier de commande utilisé dans un mode de réalisation du dispositif de l'invention ainsi que son montage sur la carrosserie du véhicule;
- la figure 3 montre une coupe selon la ligne IV-IV de la figure 2 et;
- la figure 4 montre un schéma fonctionnel du dispositif de sécurité de l'invention.

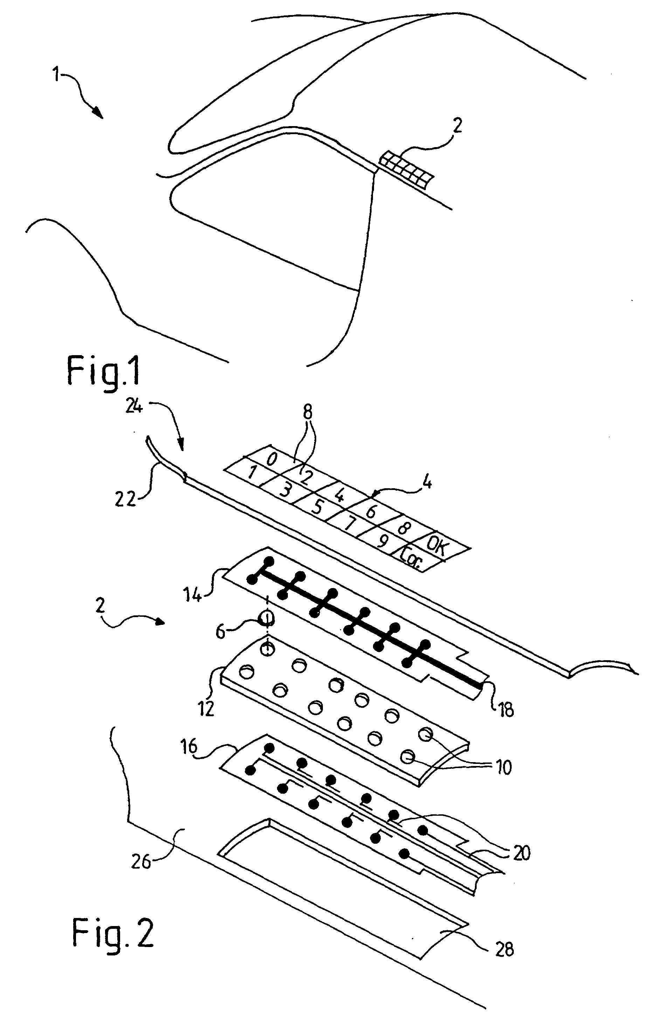

En se référant tout d'abord à la figure 1, on voit un exemple de disposition d'un clavier 2 faisant partie du dispositif de sécurité de l'invention et qui est notamment destiné à commander l'ouverture/fermeture de la porte avant-gauche d'un véhicule automobile 1 représenté schématiquement et partiellement.

Une telle disposition n'est pas obligatoire et on peut, bien entendu, disposer le clavier en tout autre endroit approprié, par exemple, sur la porte elle-même. On peut également prévoir autant de claviers que le véhicule a de portes, y compris un clavier pour le coffre à bagages, sans que cela empêche de prévoir un verrouillage et un déverrouillage centralisé de toutes les portes et/ou du coffre à partir d'un seul clavier ou de n'importe quel clavier, par exemple, celui qui est placé près de la porte du conducteur.

Selon une caractéristique de l'invention, le ou les claviers sont intégrés sous la carrosserie du véhicule par exemple sous le toit du véhicule, et sont du type "à effleurement" de sorte que la carrosserie reste d'un aspect général lisse.

Ne présentant aucune partie fonctionnelle rapportée à l'extérieur du véhicule, la représentation du ou des claviers de commande avec leurs touches seront repérés sur la surface externe de la carrosserie par tout moyen approprié, telle qu'une décoration picturale 4, qui sera prévu en regard de l'endroit où le clavier sera intégré.. Les moyens de repérage des claviers ainsi que des touches elles-mêmes sont nombreux et variés. Toutefois, on préférera utiliser un moyen de repérage, telle qu'une texturation de la surface, qui permette l'emploi du clavier en l'absence de lumière extérieure, en particulier, la nuit

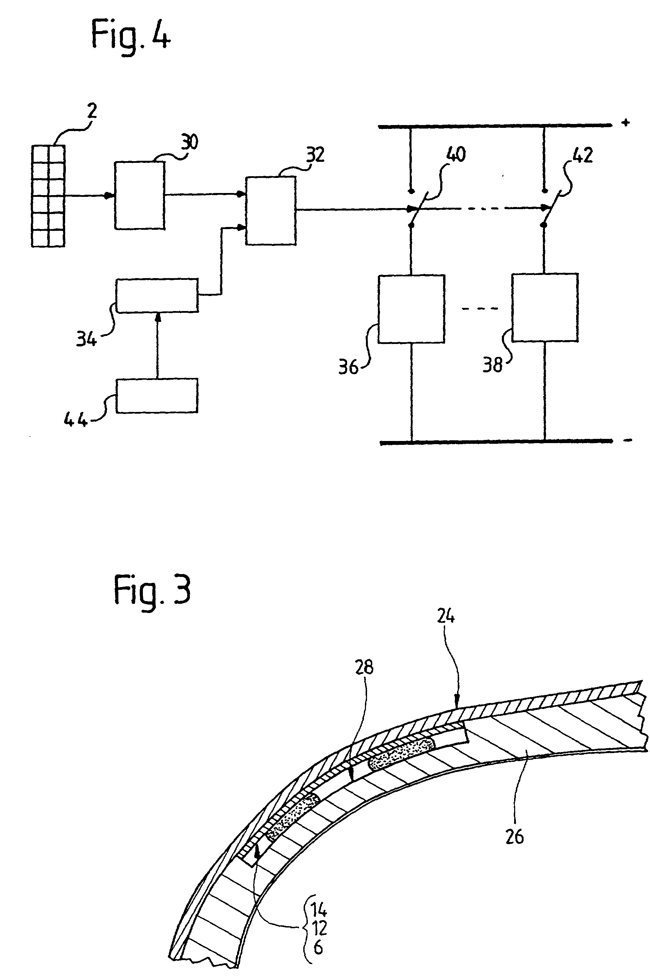

Le détail du clavier de commande 2 ainsi que son montage dans le véhicule 1 sont montrés aux figures 2 et 3. Le clavier lui-même peut être du type décrit dans le brevet Européen No. 0 210 386 de la société Dynalab AG intitulé "Folientastatur mit Piezoelektrischen Tasten".

Ce clavier comporte une pluralité de pastilles piézoélectriques 6, à savoir une pastille par touche 8 du clavier 2, disposées dans des logements 10 d'une feuille intermédiaire 12 réalisée dans un matériau rigide et servant d'entretoise, et deux films 14 et 16 portant des pistes conductrices 18, 20 permettant de connecter pour l'un (film 14), une face métallisée des pastilles 6 piézoélectriques au conducteur 18 et pour l'autre (film 16), chacune des autres faces métallisées des pastilles piézoélectriques à des conducteurs 20. Les différents éléments du clavier sont assemblés en "sandwich" et montés sur la surface intérieure 22 d'un élément de carrosserie 24 du véhicule 1 et en regard du dessin 4 (ou de tout autre élément de repérage) du clavier 2. On notera que ces éléments de clavier sont montés de façon à être maintenus en contact intime avec la surface 22.

L'élément de carrosserie 24 est suffisamment mince pour qu'il puisse se déformer à l'endroit d'une touche donnée du clavier en réponse à la pression d'un doigt. On veillera en particulier à ce que la rigidité de l'élément 24 soit telle qu'elle permette la déformation locale de l'endroit auquel la pression est exercée pour entraîner l'activation de la seule pastille piézoélectrique correspondant à la touche pressée.

Cette activation se manifeste par l'apparition d'une tension entre le conducteur commun 18 et celui des conducteurs 20 qui correspond à la pastille activée. Afin d'obtenir une efficacité maximale, le clavier sera de préférence monté entre ladite surface 22 et un élément 26 rigide et indéformable de l'infrastructure interne de la carrosserie dans lequel a été ménagé un évidemment 28 de dimensions appropriées. Le clavier 2 est par exemple fixé directement à la surface 22 au moyen d'une couche de colle d'une part et au fond de l'évidement 28 au moyen de deux bandes de colle disposées parallèlement et en regard des pastilles piézoélectriques d'autre part. La colle utilisée sera bien entendu une colle présentant une grande dureté une fois sèche.

Les claviers à éléments piézoélectriques se prêtent particulièrement bien à l'application envisagée par la présente invention. On peut, toutefois, envisager d'autres claviers de types connus présentant la particularité de ne comporter aucune pièce mobile et pouvant aisément être intégré dans un élément externe du véhicule.

A titre d'exemple, on pourrait utiliser un clavier dit "à touches capacitives" et consistant en deux réseaux croisés de conducteurs, maintenus à faible distance l'un de l'autre par un matériau diélectrique. Un contact du doigt en un point du double réseau a pour effet de modifier localement la capacité; modification qui peut être détectée par un circuit électronique approprié. Un tel clavier pourrait être réalisé dans les vitres du véhicule ou encore dans un élément de carrosserie, pour autant que celle-ci soit en un matériau isolant.

Un autre exemple de clavier peut consister en l'utilisation d'un clavier dit "à touches résistives" du type de celui décrit dans le brevet US 4,451 714 au nom de F. N. Eventoff et al. consistant en deux réseaux croisés de conducteurs, maintenus à faible distance l'un de l'autre par un matériau semiconducteur sensible à la pression. Un contact du doigt en un point du double réseau a pour effet de modifier localement la résistance des conducteurs; modification qui peut être détectée par un circuit électronique approprié.

Un exemple de schéma fonctionnel du dispositif de sécurité de l'invention est montré à la figure 4.

Les conducteurs de sortie du clavier 2 sont reliés à un circuit décodeur 30. Le code de sortie du circuit 30 est appliqué à un comparateur 32 qui reçoit également un ou plusieurs codes fournis par un registre de mémoire 34. Lorsque le code introduit et le ou les codes du registre 34 sont identiques, un signal de commande est transmis à un ou plusieurs actionneurs 36, 38 via les interrupteurs 40 et 42, respectivement. Dans l'application envisagée, l'actionneur 36 est, par exemple, un électro-aimant qui assure le verrouillage et/ou le déverrouillage des portes. A ce propos, on pourra prévoir un code pour la commande du verrouillage par exemple l'actionnement simultané de trois touches quelconques et un autre code pour le déverrouillage par exemple une combinaison de touches déterminée..

Selon une variante particulièrement utile pour faire échec à toute tentative de vol par effraction, le code de déverrouillage introduit par le clavier 2 et correspondant à celui qui est mémorisé est également utilisé pour inhiber le système de coupe-circuit ou coupe-contact du véhicule. Ainsi, dans la figure 4 l'interrupteur 42 est placé en série avec le commutateur du contact de démarreur 38. La mémoire 34 renfermant le code de déverrouillage doit bien sûr pouvoir être programmée, soit une fois pour toutes par le fabricant, soit par l'utilisateur au gré de ses besoins. Dans ce dernier cas, il est nécessaire de prévoir un programmateur 44 pour introduire le code dans la mémoire 34. Ce programmateur peut être un clavier disposé à l'intérieur du véhicule.

Il est clair que les exemples de réalisation décrits peuvent subir des variantes ou modifications sans sortir du cadre de l'invention.

L'utilisation d'un dispositif tel que celui qui vient d'être décrit présente bien des avantages sur les systèmes à serrure classiques. En premier lieu, aucun élément annexe, tels une clef ou un émetteur, n'est requis pour commander l'ouverture et/ou la fermeture, notamment de porte de véhicule automobile. Par ailleurs, un tel dispositif constitue une protection efficace contre le vol et l'effraction puisque la connaissance du code d'ouverture est indispensable. On notera également qu'un tel dispositif utilisant un clavier offre un plus grand nombre de combinaisons différentes possibles que les systèmes à clef ou à émetteur.

## Revendications

1. Dispositif de sécurité destiné à l'ouverture et/ou à la fermeture d'au moins une porte d'un véhicule automobile, **caractérisé en ce qu'**il comporte:
- au moins un clavier de commande, ledit clavier de commande comprenant au moins une touche pour introduire un code d'ouverture et/ou un code de fermeture, lesdites touches faisant partie intégrale d'un élément de carrosserie du véhicule et formant une surface extérieure continue dudit élément de carrosserie, ledit clavier étant muni d'éléments capteurs associés chacun à une touche correspondante, et situés sous ladite surface continue, lesdits éléments capteurs étant sensibles au toucher de ladite surface continue pour délivrer un code correspondant à la touche activée;
- un circuit (30, 32, 34, 44) apte à engendrer un signal de commande en réponse audit code délivré par le clavier de commande; et
- des moyens d'actionnement (36, 38) commandés par ledit signal de commande et assurant le verrouillage et/ou le déverrouillage de ladite porte.

2. Dispositif de sécurité selon la revendication 1, **caractérisé en ce que** lesdits éléments capteurs (6) sont des éléments piézoélectriques et **en ce que** ledit clavier de commande est monté sous une partie (24) de la carrosserie du véhicule.

3. Dispositif de sécurité selon la revendication 1, **caractérisé en ce que** le clavier de commande (2) est du type capacitif et **en ce qu'**il est monté dans un élément du véhicule réalisé dans un matériau isolant.

4. Dispositif de sécurité selon la revendication 1, **caractérisé en ce que** le clavier de commande (2) est du type résistif.

5. Dispositif de sécurité selon l'une quelconque des revendications 1 à 4, **caractérisé en ce que** ledit circuit comporte une mémoire (34) dans laquelle est enregistré un code de référence et **en ce que** ledit signal de commande n'est délivré que si le code introduit sur le clavier (2) est identique à ce code de référence.

6. Dispositif de sécurité selon l'une quelconque des revendications 1 à 5, **caractérisé en ce que** ledit signal de commande est utilisé en outre pour fermer le circuit du contact de démarreur du véhicule.

7. Dispositif de sécurité selon l'une quelconque des revendications 1 à 6, **caractérisé en ce que** les touches du clavier sont repérées au moyen d'une image (4) réalisée sur la surface externe du véhicule.

8. Dispositif de sécurité selon la revendication 7, **caractérisé en ce que** ladite image (4) présente une configuration en relief.

## Claims

1. Security arrangement intended for the opening and/or closing of at least one door of an automotive vehicle, **characterized in that** it includes :
- at least one control keyboard, said control keyboard comprising at least a key for the introduction of an opening and/or closing code, said keys being integral with the coachwork of the vehicle and forming a continuous exterior surface of said vehicle coachwork, said keyboard being provided with sensing elements each associated to a corresponding key, and situated under said continuous surface, said sensing elements being responsive to the touch of said continuous surface in order to supply a code corresponding to the actuated key;
- a circuit (30, 32, 34, 44) adapted to generate a control signal in response to said code furnished by the control keyboard, and
- actuating means (36, 38) controlled by said control signal and assuring the latching and/or unlatching of said door.

2. Security arrangement according to claim 1, **characterized in that** said sensing elements (6) are piezo-electric elements and **in that** said control keyboard is mounted under a part (24) of the vehicle coachwork.

3. Security arrangement according to claim 1, **characterized in that** the control keyboard (2) is of the capacitive type and that it is mounted in an external element of the vehicle formed from an insulating material.

4. Security arrangement according to claim 1, **characterized in that** the control keyboard (2) is of the resistive type.

5. Security arrangement according to any one of the claims 1 to 4, **characterized in that** said circuit includes a memory (34) in which is stored a reference code and **in that** said control signal is furnished only if the code introduced into the keyboard (2) is identical to such reference code.

6. Security arrangement according to any one of claim 1 to 5, **characterized in that** said control signal is additionally employed to close the contact control circuit of the vehicle starter.

7. Security arrangement according to any one of claims 1 to 6, **characterized in that** the keys of the keyboard are located by means of an image (4) formed on the outer surface of the vehicle.

8. Security arrangement according to claim 7, **characterized in that** said image (4) exhibits an outline in relief.

## Patentansprüche

1. Sicherheitsvorrichtung, die zum Öffnen und/oder Schließen wenigstens einer Tür eines Kraftfahrzeugs bestimmt ist, **dadurch gekennzeichnet, daß** sie umfaßt:
- wenigstens eine Steuertastatur, die wenigstens eine Taste zum Eingeben eines Öffnungscodes und/oder eines Schließcodes aufweist, wobei die Tasten einteilig mit einem Karosserieelement des Fahrzeugs ausgebildet sind und eine ununterbrochene äußere Oberfläche des Karosserieelements bilden, wobei die Tastatur mit Sensorelementen versehen ist, die jeweils einer entsprechenden Taste zugeordnet sind und sich unter der ununterbrochenen Oberfläche befinden, wobei die Sensorelemente auf Berührung der ununterbrochenen Oberfläche empfindlich sind, um zu der aktivierten Taste einen entsprechenden Code zu liefern;
- einen Schaltkreis (30, 32, 34, 44), der als Antwort auf den von der Steuertastatur gelieferten Code ein Steuersignal erzeugen kann; und
- Betätigungsmittel (36, 38), die durch das Steuersignal gesteuert werden und die Verriegelung und/oder die Entriegelung der Tür gewährleisten.

2. Sicherheitsvorrichtung nach Anspruch 1, **dadurch gekennzeichnet, daß** die Sensorelemente (6) piezoelektrische Elemente sind und daß die Steuertastatur unter einem Teil (24) der Fahrzeugkarosserie angebracht ist.

3. Sicherheitsvorrichtung nach Anspruch 1, **dadurch gekennzeichnet, daß** die Steuertastatur (2) vom kapazitiven Typ ist und daß sie in einem Fahrzeugelement angebracht ist, das aus einem Isolierwerkstoff hergestellt ist.

4. Sicherheitsvorrichtung nach Anspruch 1, **dadurch gekennzeichnet, daß** die Steuertastatur (2) vom ohmschen Typ ist.

5. Sicherheitsvorrichtung nach einem der Ansprüche 1 bis 4, **dadurch gekennzeichnet, daß** die Schaltung einen Speicher (34) enthält, in dem ein Referenzcode gespeichert ist, und daß das Steuersignal nur geliefert wird, wenn der in die Tastatur (2) eingegebene Code mit diesem Referenzcode übereinstimmt.

6. Sicherheitsvorrichtung nach einem der Ansprüche 1 bis 5, **dadurch gekennzeichnet, daß** das Steuersignal außerdem dazu verwendet wird, den Kontaktschaltkreis für den Anlasser des Fahrzeugs zu schließen.

7. Sicherheitsvorrichtung nach einem der Ansprüche 1 bis 6, **dadurch gekennzeichnet, daß** die Tasten der Tastatur durch ein Bild (4), das auf der äußeren Oberfläche des Fahrzeugs ausgebildet ist, **gekennzeichnet** sind.

8. Sicherheitsvorrichtung nach Anspruch 7, **dadurch gekennzeichnet, daß** das Bild (4) eine Reliefkonfiguration aufweist.
